# EUROPEAN PATENT APPLICATION

(11) **EP 1 850 405 A1**
(43) Date of publication of application: **31.10.2007**
(21) Application number: 05819873.0
(22) Date of filing: 26.12.2005
(51) Int. Cl.: H01L 51/50, C09D 11/00, C09K 11/06, H05B 33/10

(54) **INK FOR FORMING ORGANIC EL COATING FILM AND METHOD FOR PRODUCTION THEREOF**

(30) Priority: 28.12.2004 JP 2004379561
(71) Applicant: IDEMITSU KOSAN CO., LTD., Tokyo 100-8321 (JP)
(72) Inventor: INOUE, Tetsuya, Chiba 2990293 (JP); KONDO, Hirofumi, Chiba 2990293 (JP); JUNKE, Tadanori, Chiba 2990293 (JP); IKEDA, Hidetsugu, Chiba 2990293 (JP)
(74) Representative: Gille Hrabal Struck Neidlein Prop Roos
(86) International application number: PCT/JP2005/023711
(87) International publication number: WO 2006/070711

(57) **Abstract**

An ink for forming an organic electroluminescent coating film capable of forming an emitting layer with a long life, which has a water concentration of 20 ppm or less and an oxygen concentration of 10 ppm or less wherein an aromatic compound, preferably an anthracene derivative, a pyrene derivative, and/or a fluorene derivative, is dissolved into an organic solvent, and a production method thereof are provided.

## Description

### TECHNICAL FIELD

The invention relates to an ink for forming an organic electroluminescent (EL) coating film and a method for production thereof.

### BACKGROUND

An organic EL device is a self-emission type display device which has advantages of having a wide view angle, an excellent contrast, and a quick response time. An EL device is divided into an inorganic EL device and an organic EL device depending on the type of materials forming an emitting layer. As compared with an inorganic EL device, an organic EL device is excellent in luminance, driving voltage, and response speed characteristics, and can display multiple colors.

In general, the organic EL device includes an emitting layer and a pair of opposite electrodes holding the emitting layer therebetween. When an electric field is applied between the electrodes of the organic EL device, electrons are injected from the cathode and holes are injected from the anode. The electrons recombine with the holes in an emitting layer to produce an excited state, and energy is emitted as light when the excited state returns to the ground state. The EL device emits light by utilizing this phenomenon.

A variety of low-molecular compounds have been developed as a material for forming an emitting layer. For example, an organic El device utilizing an aromatic diamine and an aluminum complex is reported in Non-Patent Document 1. Also, luminescent materials such as coumarin derivatives, tetraphenylbutadiene derivatives, bisstyrylarylene derivatives, and oxadiazole derivatives are known. Emission of light in the visible range from blue to red can be obtained from these luminescent materials. Therefore, a color display device using such luminescent materials are expected to be realized (Patent Documents, 1, 2 and 3, for example). Further, a device using an anthracene derivative is reported (Patent Documents 4, 5, 6 and 7, for example). These derivatives, however, have a low luminous efficiency, and hence, a luminescent material with a higher luminous efficiency is desired.
On the other hand, an organic electronic emitting device using a high-molecular compound such as poly(p-phenylenevinylene)(PPV), poly(2-methoxy-5-(2'-ethylhexyloxy)-1,4-phenylenevinylene, or the like is reported (Non-Patent Document 2). Further, a soluble PPV into which a functional group is introduced to improve solubility properties for an organic solvent has been developed. Use of such a soluble PPV enables formation of a solution for forming a film by a wet method. As a result, an emitting layer can be formed by a wet film-forming method such as spin coating and inkjet (Patent Document 8, for example). The wet film-forming method facilitates fabrication of a device and enables fabrication of a large-sized device. However, a high-molecular compound is inferior to a low-molecular compound in emission performance, and hence, insufficient as an ink for forming an emitting layer in respect of emitting performance.

Many of low-molecular luminescent compounds which have heretofore been known are hardly soluble. Therefore, an emitting layer is normally formed by vacuum deposition. Vacuum deposition has, however, many disadvantages such as complicated process and need for a large-sized deposition apparatus. Therefore, fabrication of a device by the wet film-forming method using a low-molecular compound has been desired.

Low-molecular luminescent compounds have such advantages that they can be produced readily by a shorter synthesis route as compared with PPV, and can be purified to a high purity by a known method such as column chromatography. Therefore, low-molecular compounds can be a luminescent material exhibiting high emitting performance without being greatly effected by impurities which are mixed in.

[Patent Document 1] JP-A-H8-239655
[Patent Document 2] JP-A-H7-138561
[Patent Document 3] JP-A-H3-200289
[Patent Document 4] U.S.P. No. 0593572
[Patent Document 5] JP-A-H8-012600
[Patent Document 6] JP-A-2000-344691
[Patent Document 7] JP-A-H11-323323
[Patent Document 8] JP-A-2003-308969
[Non-Patent Document 1] Appl. Phys. Lett. 51,913,1987
[Non-Patent Document 2] Nature,347,539,1990 & Appl. Phys. Lett. 58, 1982, 1991

An object of the invention is to provide an ink for forming an organic EL coating film which can form an emitting layer with a long life, and a method for production thereof.

### SUMMARY OF THE INVENTION

1. An ink for forming an organic electroluminescent coating film having a water concentration of 20 ppm or less and an oxygen concentration of 10 ppm or less wherein an aromatic compound is dissolved in an organic solvent.
2. The ink for forming an organic electroluminescent coating film according to 1 wherein the aromatic compound is an anthracene derivative, a pyrene derivative, and/or a fluorene derivative.
3. The ink for forming an organic electroluminescent coating film according to 2 wherein the fluorene derivative is an oligofluorenylene compound represented by the following formula: 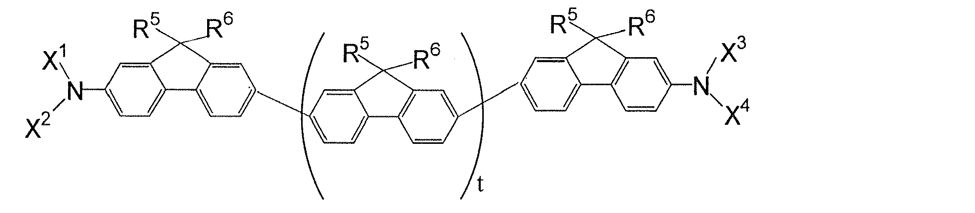 wherein X¹ to X⁴ are a group selected from the group consisting of substituted or unsubstituted alkyl, aralkyl, aryl and heterocycle, substituted or unsubstituted alkenyl having a substituted or unsubstituted arylene or linking group formed of a divalent heterocyclic group, alkynyl, amino, alkoxy, sulfide, substituted silyl having a substituted or unsubstituted arylene group or linking group formed of a divalent heterocyclic group, and carbonyl; X¹ to X⁴ may be the same or different; X¹ and X², and X³ and X⁴ may be bonded together to form a ring;
   R⁵ and R⁶ are a group selected from the group consisting of hydrogen, substituted or unsubstituted alkyl, aralkyl and aryl; R⁵ and R⁶ may be the same or different; R⁵s or R⁶s bonding different fluorenylene rings may be the same or different; and
   t is an integer of 1 to 20.
4. The ink for forming an organic electroluminescent coating film according to any one of 1 to 3 wherein the organic solvent is a non-halogen solvent.
5. The ink for forming an organic electroluminescent coating film according to 4 wherein the organic solvent is an aromatic solvent.
6. The ink for forming an organic electroluminescent coating film according to any one of 1 to 3 wherein the organic solvent is a non-halogen solvent.
7. A method for producing the ink for forming an organic electroluminescent coating film of any one of 1 to 6 comprising dissolving an aromatic compound into an organic solvent having a water concentration of 20 ppm or less and an oxygen concentration of 10 ppm or less.
8. An organic electroluminescent device produced by using the ink for forming an organic electroluminescent coating film of any one of 1 to 6.

The invention provides an ink for forming an organic EL coating film capable of forming an emitting layer with a long life and a method for production thereof.

### BRIEF DESCRIPTION OF DRAWINGS

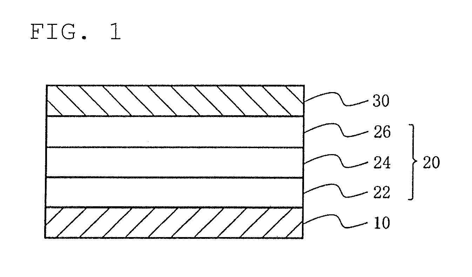

FIG. 1 is a cross-sectional view showing an embodiment of an organic EL device according to the invention.

### BEST MODE FOR CARRYING OUT THE INVENTION

The ink for forming an organic EL coating film of the invention is prepared by dissolving an aromatic compound in an organic solvent. The concentration of the aromatic compound is preferably 0.5 wt% or more.

Preferred aromatic compounds used for the ink include anthracene derivatives, pyrene derivatives and/or fluorene derivatives. The aromatic compounds also include fluorenylanthracene derivatives or fluorenylpyrene derivatives.

Preferred anthracene derivatives, pyrene derivatives and/or fluorene derivatives are shown below. 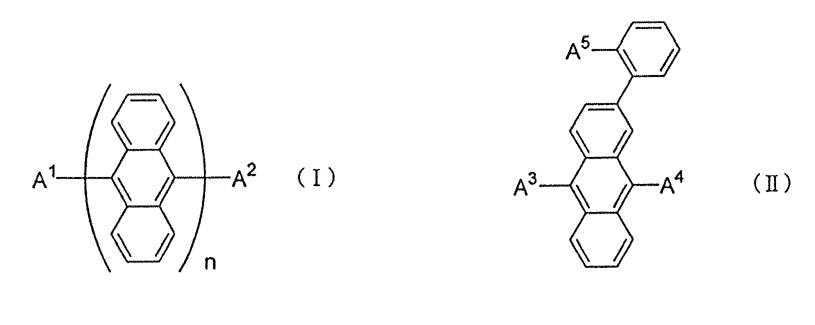 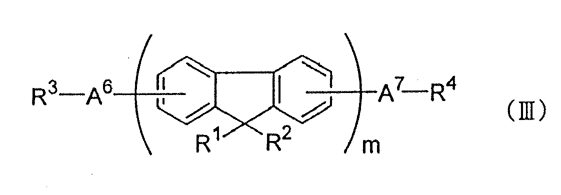 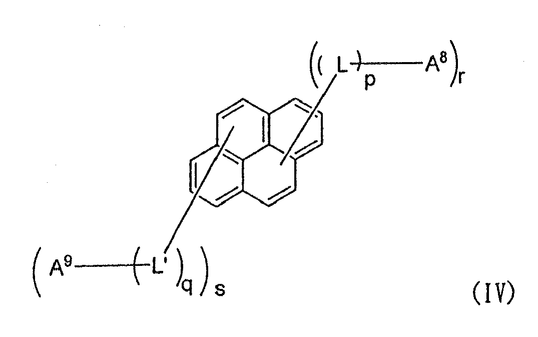 In the formula (I), A¹ and A² are an aryl group having 6 to 50 nucleus carbon atoms which may have a substituent or a heteroaryl group having 5 to 50 nucleus atoms which may have a substituent; A¹ and A² are not the same; and n is an integer of 1 to 2.

In the formula (II), A³ to A⁵ are an aryl group having 6 to 50 nucleus carbon atoms which may have a substituent or a heteroaryl group having 5 to 50 nucleus atoms which may have a substituent; and A³ to A⁵ may be the same or different.

In the formula (III), A⁶ and A⁷, which may be the same or different, are anthracenylene or pyrenylene; m is an integer of 1 to 3; R¹ and R², which may be the same or different, are hydrogen or an alkyl group having 1 to 10 carbon atoms; R³ and R⁴, which may be the same or different, are hydrogen, a phenyl group or a biphenyl group which is substituted by an alkyl group having 1 to 6 carbon atoms.
Preferably, A⁶ and A⁷ are the same, R¹ and R² are the same and are an alkyl group having 4 to 10 carbon atoms, and R³ and R⁴ are the same.

In the formula (IV), L and L' are independently a substituted or unsubstituted phenylene group, a substituted or unsubstituted naphtharenylene group, a substituted or unsubstituted fluorenylene group, or a substituted or unsubstituted dibenzosilolylene group; A⁸ and A⁹ are independently a substituted or unsubstituted aromatic group having 6 to 50 nucleus carbon atoms; p and q are an integer of 0 to 2; r is an integer of 1 to 4; and s is an integer of 0 to 4.

As the fluorene derivative, the following oligofluorenyrene compound is preferable. 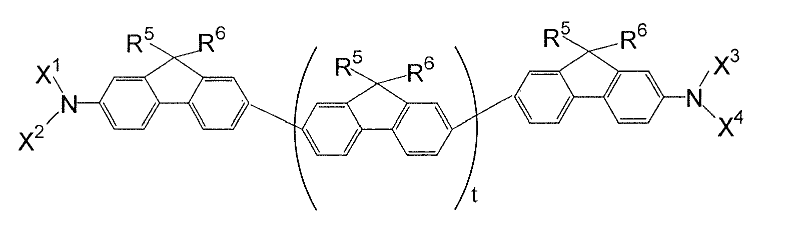 wherein X¹ to X⁴ are a group selected from the group consisting of substituted or unsubstituted alkyl, aralkyl, aryl and heterocycle, substituted or unsubstituted alkenyl having a substituted or unsubstituted arylene group or linking group formed of a divalent heterocyclic group, alkynyl, amino, alkoxy, sulfide, substituted silyl having a substituted or unsubstituted arylene group or linking group formed of a divalent heterocyclic group, and carbonyl; X¹ to X⁴ may be the same or different; X¹ and X², and X³ and X⁴ may be bonded together to form a ring;
R⁵ and R⁶ are a group selected from the group consisting of hydrogen, substituted or unsubstituted alkyl, aralkyl and aryl; R⁵ and R⁶ may be the same or different; R⁵s or R⁶s bonding different fluorenylene rings may be the same or different; and t is an integer of 1 to 20.

Specific examples of the aromatic compound are shown below, but not limited thereto. 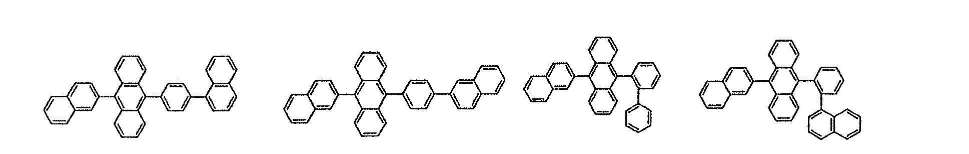 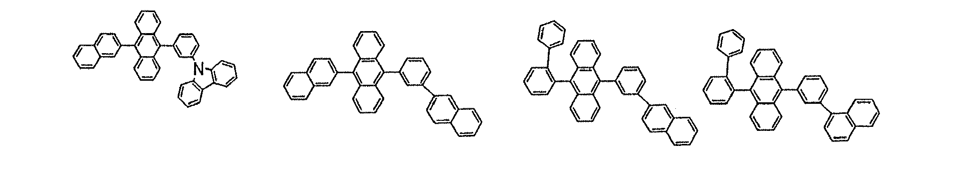 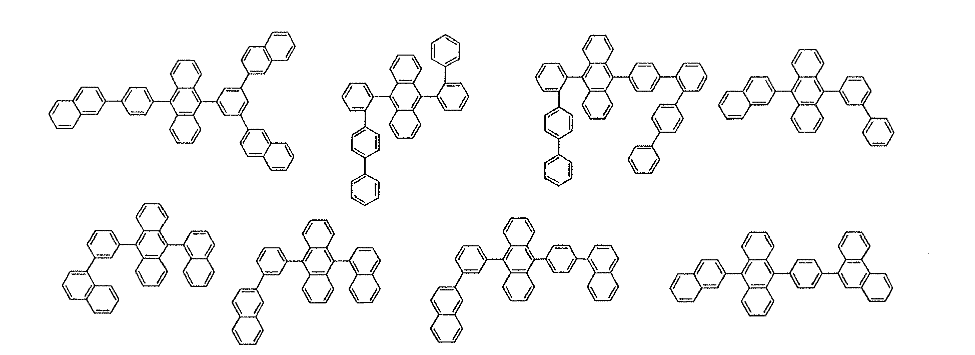 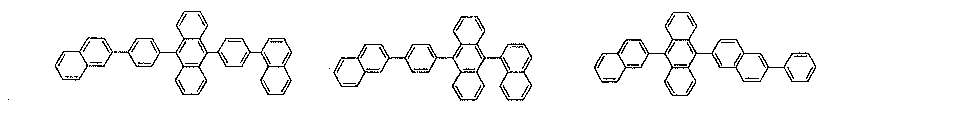 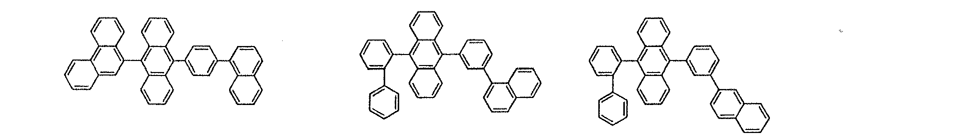 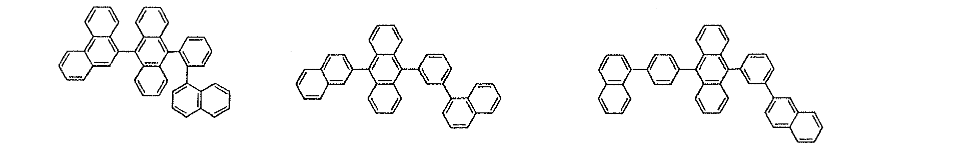 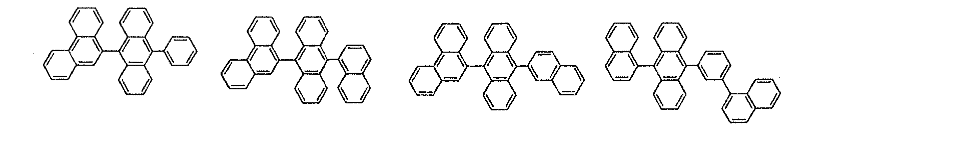 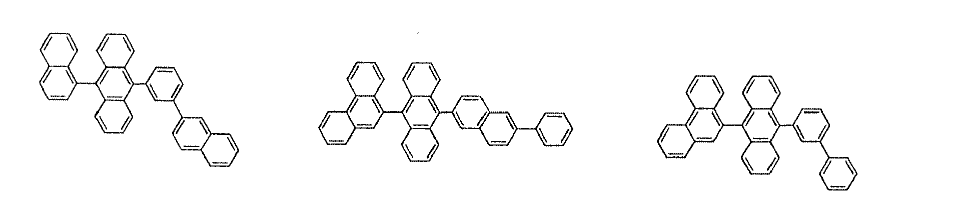 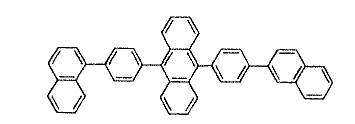 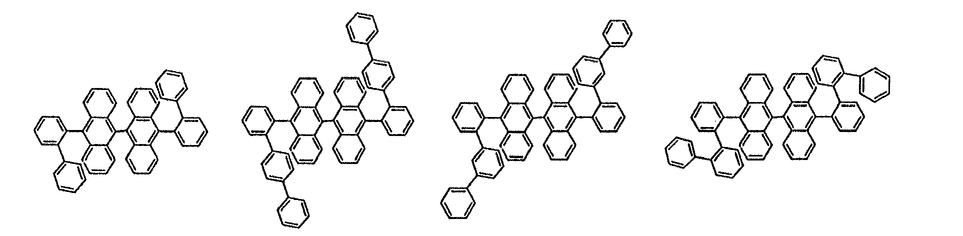 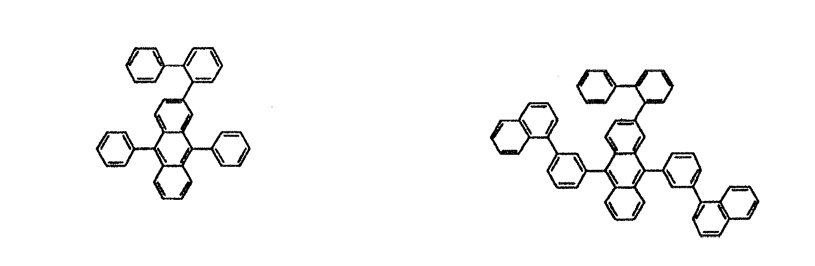 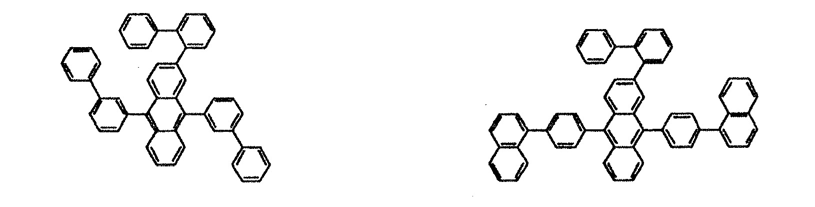 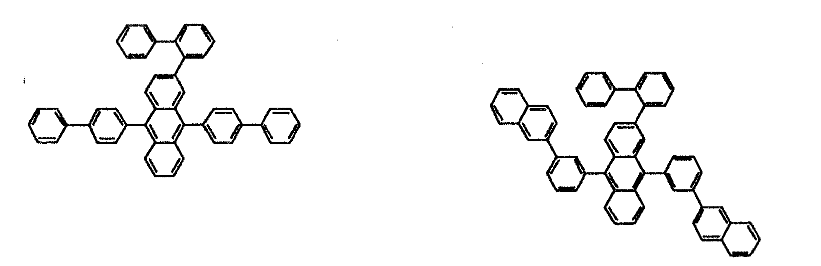 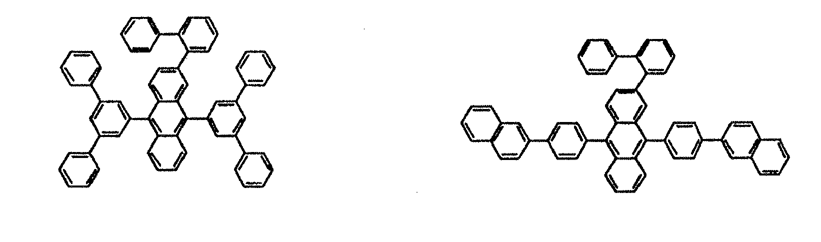 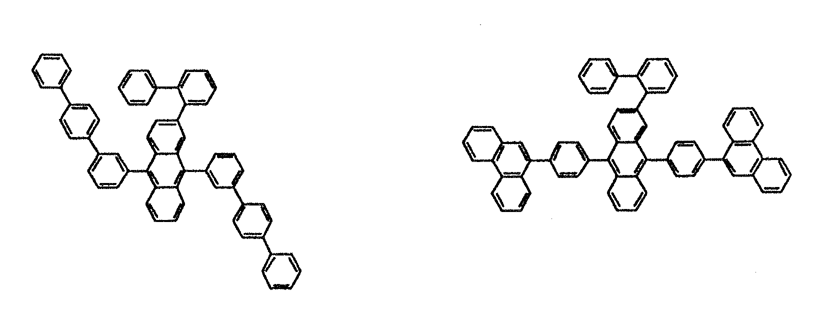 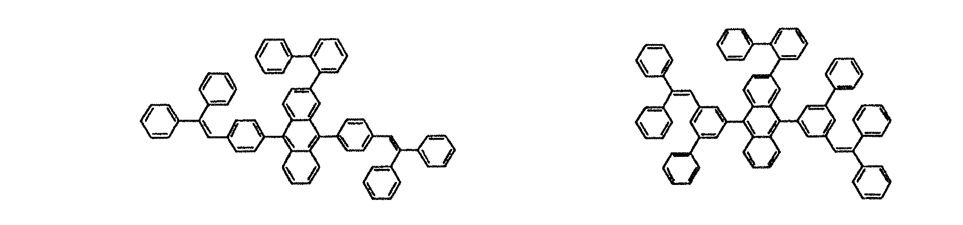 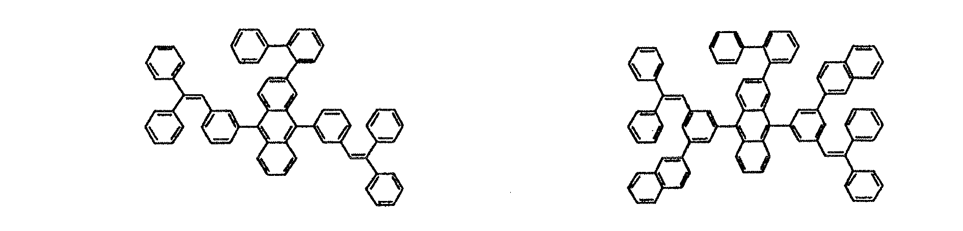 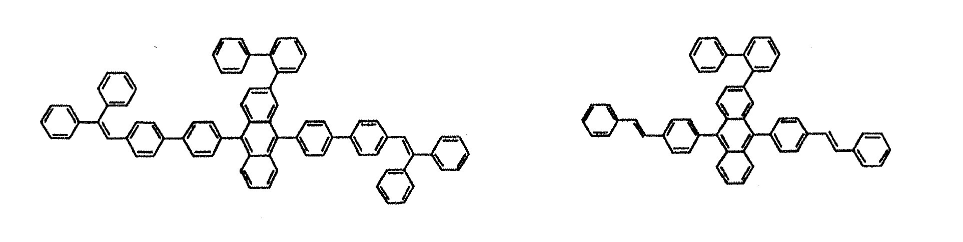 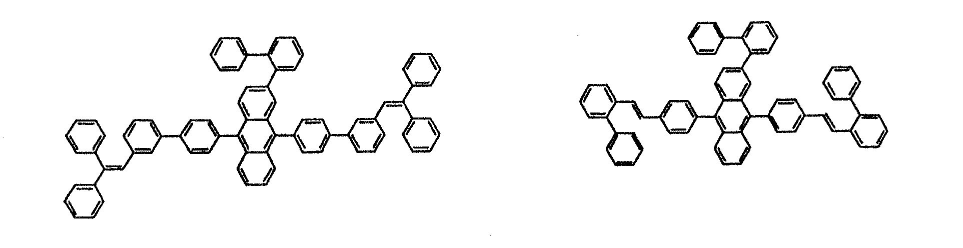 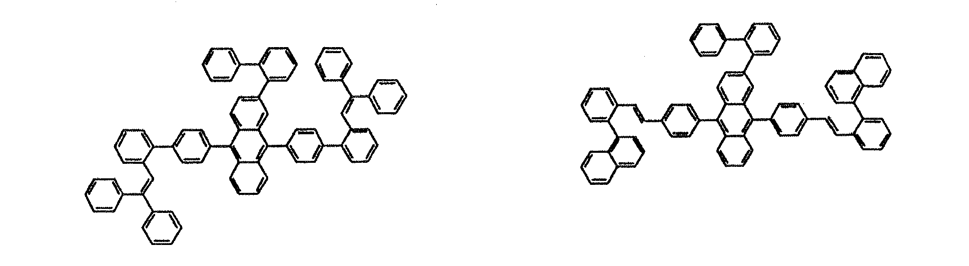 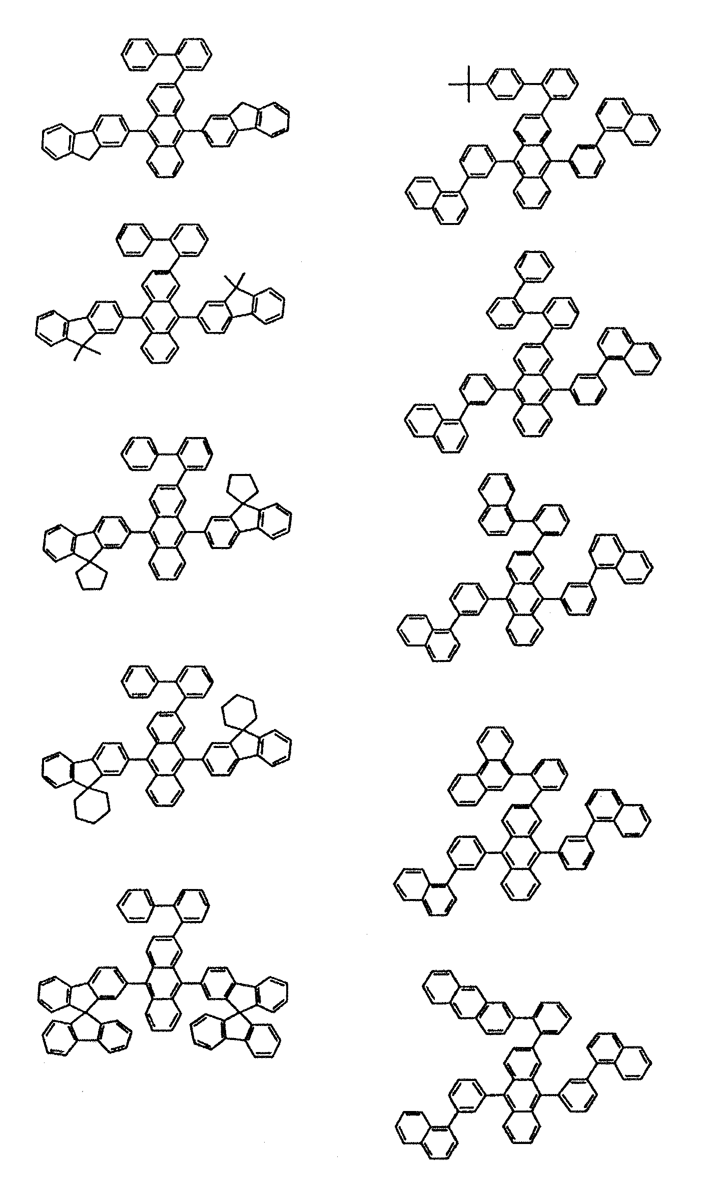 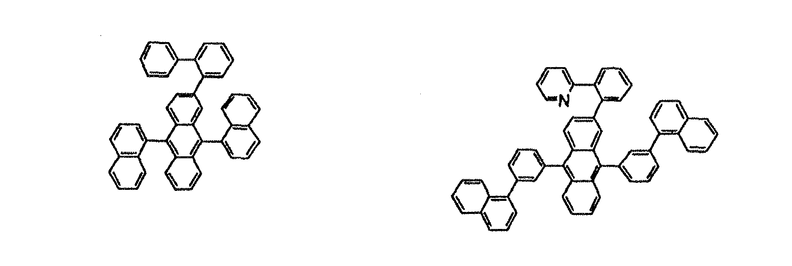 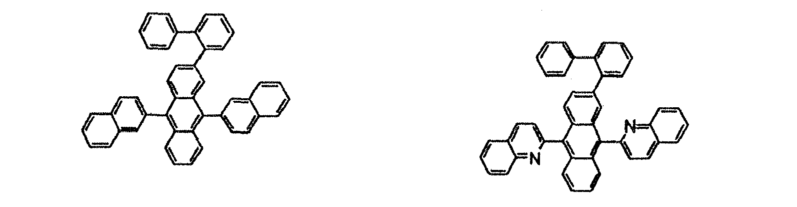 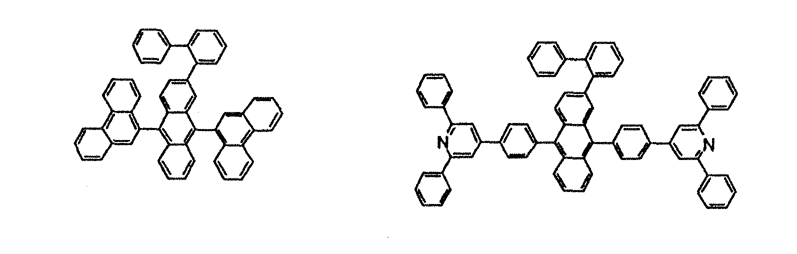 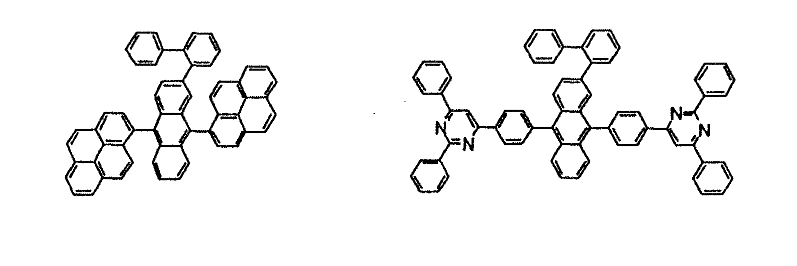 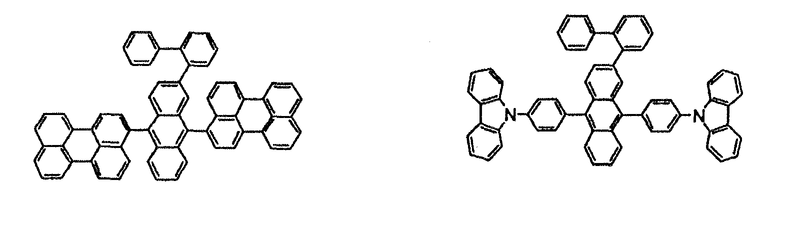 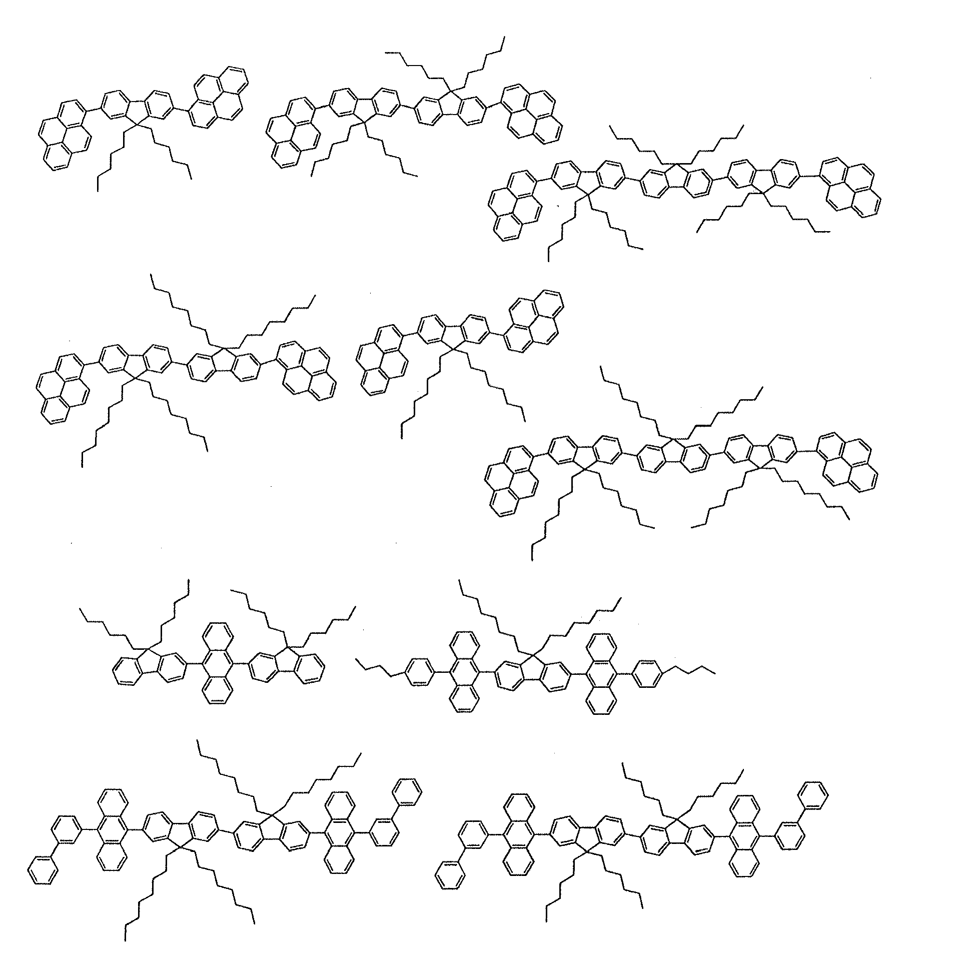 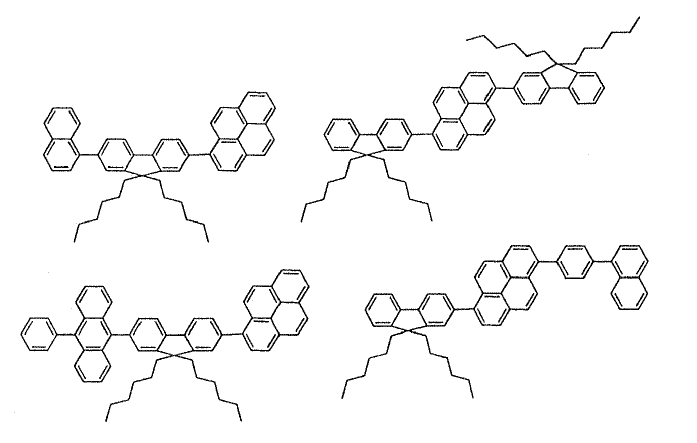 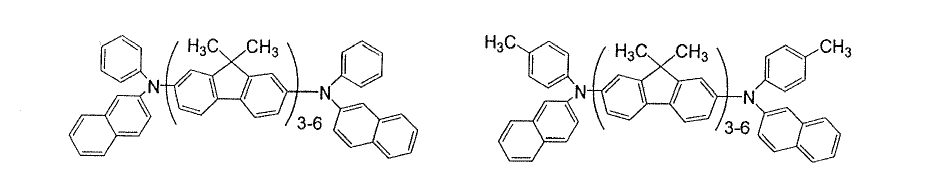 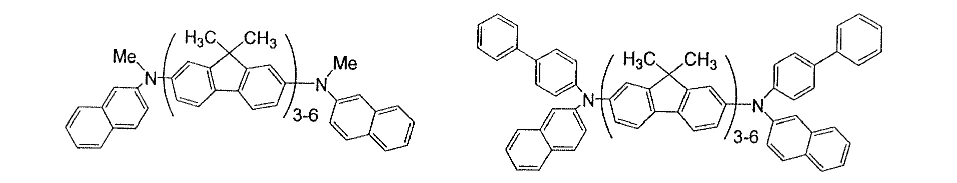 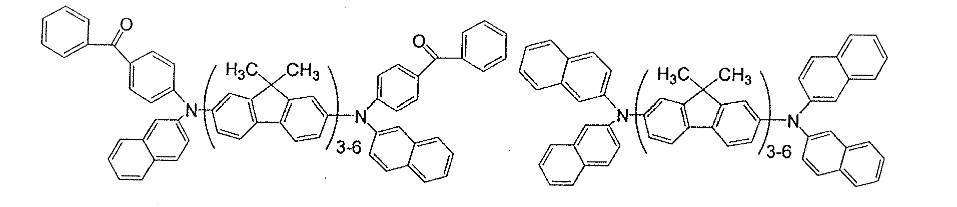 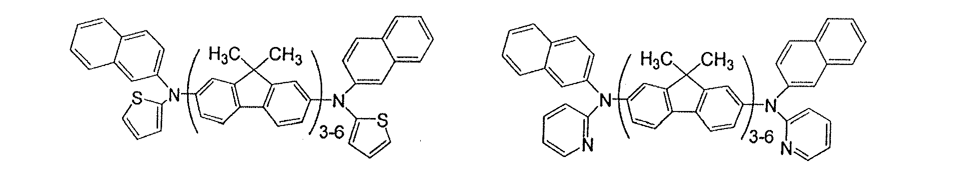 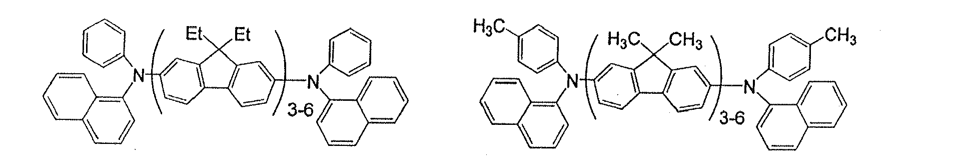 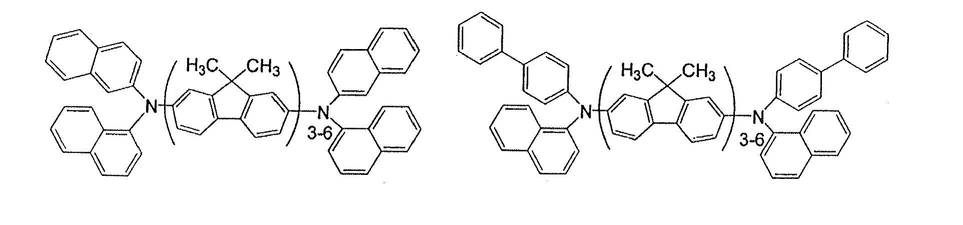 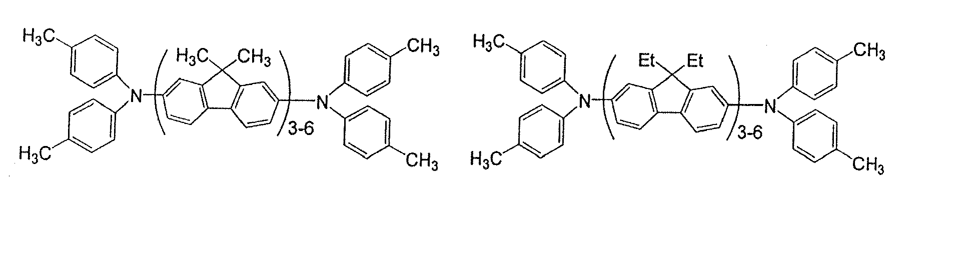 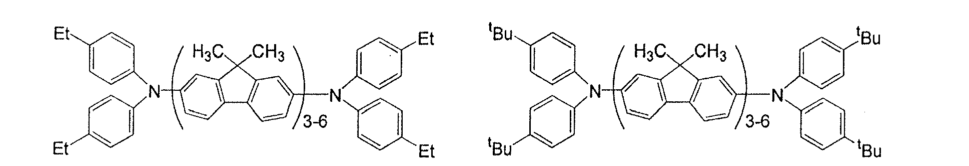 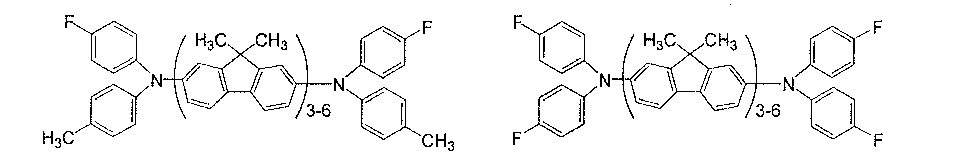 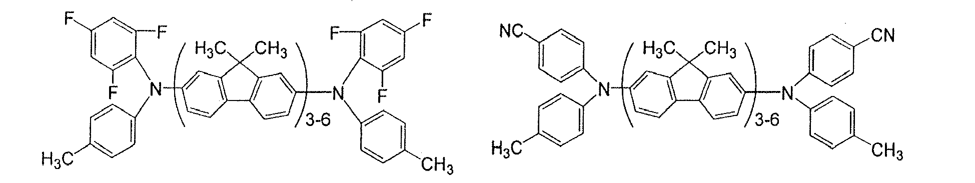 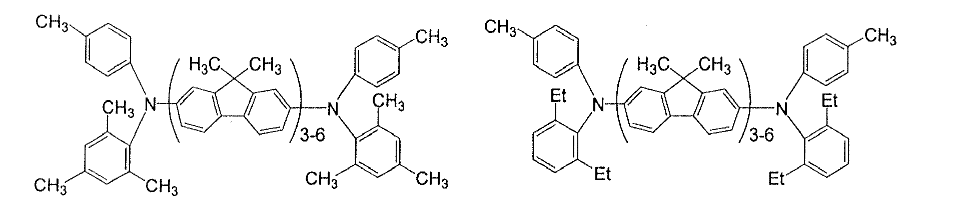 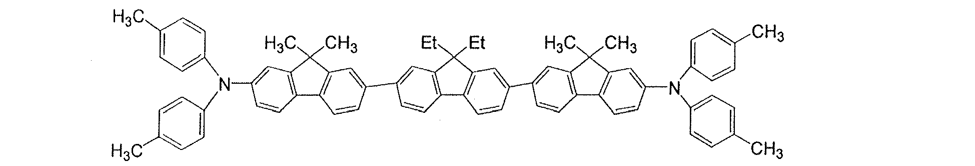 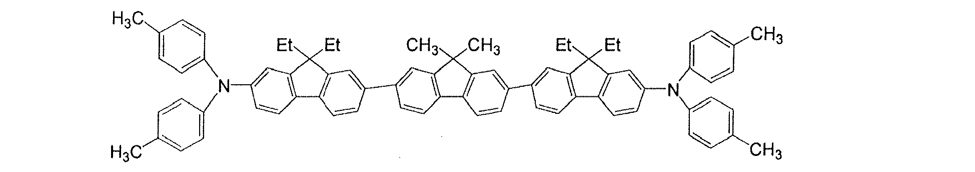 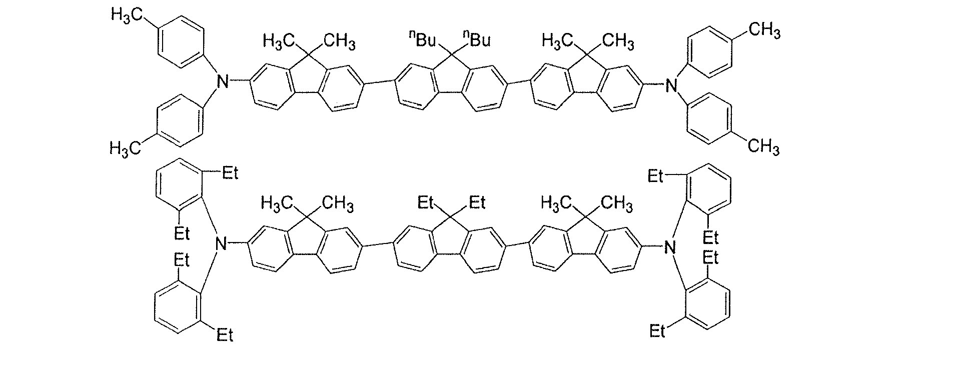 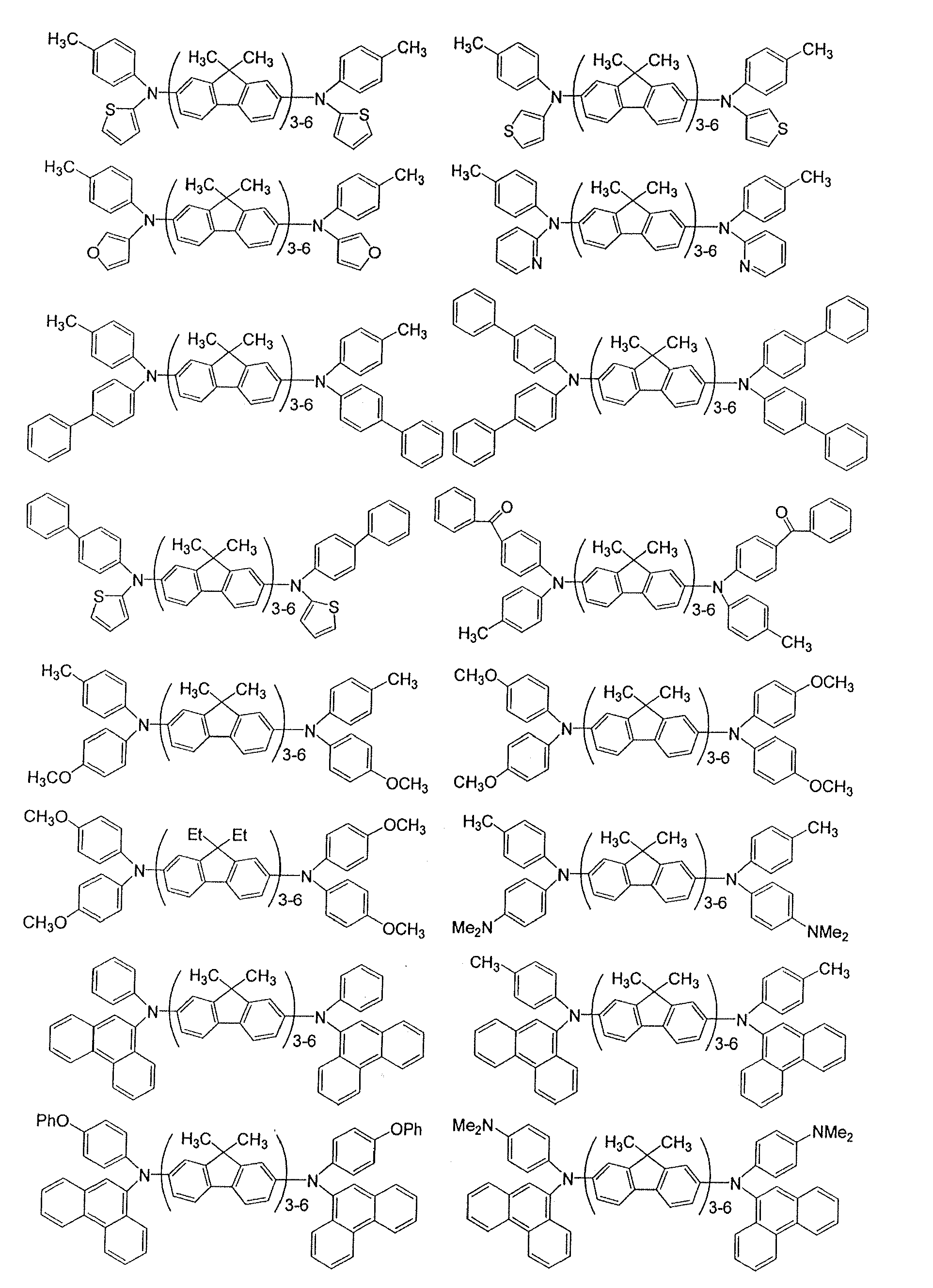 Me, Et, ^{t}Bu, ⁿBu and Ph are abbreviations for methyl, ethyl, tert-butyl, normal butyl, and phenyl.

The organic solvents for dissolving the above-mentioned aromatic compounds include non-halogen solvents and halogen solvents.
Examples of the non-halogen solvents include ether solvents such as dibutyl ether, tetrahydrofuran, dioxane and anisole; alcohol solvents such as methanol, ethanol, propanol, buthanol, pentanol, hexanol, cyclohexanol, methyl cellosolve, ethyl cellosolve, and ethylene glycol; aromatic solvent such as benzene, toluene, xylene, and ethylbenzene; hydrocarbon solvents such as hexane, octane, and decane; and ester solvents such as ethyl acetate, butyl acetate, and amyl acetate. Of these non-halogen solvents, aromatic solvents are preferable.

Examples of the halogen solvents include dichloromethane, dichloroethane, chloroform, carbon tetrachloride, tetrachloroethane, trichloroethane, chlorobenzene, dichlorobenzene, and chlorotoluene.
These solvents may be used either singly or in combination of two or more. The usable solvents are not limited to those mentioned above.

The water concentration and the oxygen concentration of the ink for forming the organic EL coating film of the invention are 20 ppm or less and 10 ppm or less, respectively. When the water concentration and the oxygen concentration of the ink are large, the luminous performance of the emitting device is deteriorated, whereby the life of the device is shortened. It is preferred that the water concentration and the oxygen concentration be 10 ppm or less and 5 ppm or less, respectively.

A method for producing the ink for forming an organic EL coating film having a water concentration of 20 ppm or less and an oxygen concentration of 10 ppm or less is explained below.
Such an ink can be produced by dissolving an aromatic compound in an organic solvent having a water concentration of 20 ppm or less and an oxygen concentration of 10 ppm or less. As the common method to lower the water concentration and the oxygen concentration of an organic solvent, purification by distillation, bubbling using an inert gas such as argon and nitrogen, drying using a desiccant represented by a molecular sieve, using a degasser, freeze drying or the like can be given.

An organic EL device can be fabricated by forming films by a wet method using the above-mentioned ink. As the wet method, spin coating, inkjet, or the like can be exemplified. In general, an organic EL device includes a pair of opposite electrodes and an emitting layer or stacked layers including an emitting layer being interposed therebetween. At least one of these layers can be formed using the ink of the invention. It is preferred that the emitting layer be formed using the ink.

FIG. 1 is a cross-sectional view showing an embodiment of the organic EL device according to the invention.
In this organic EL device, an organic thin layer 20 which is composed of a hole-injecting layer 22, an emitting layer 24, and an electron-injecting layer 26 is interposed between a cathode 30 and an anode 10. At least one of the hole-injecting layer 22, the emitting layer 24, and the electron-injecting layer 26 can be produced using the ink of the invention.

When the emitting layer is produced using the ink of the invention, the above-mentioned anthracene derivatives, pyrene derivatives and/or fluorene derivatives can be used as a host material. It is preferred that a styrylamine compound and/or an arylamine compound be contained in the emitting layer as a dopant.
A preferred styrylamine compound is represented by the following formula (1).

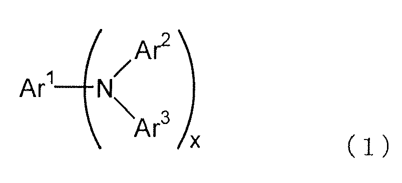

wherein Ar¹ is a group selected from phenyl, terphenyl, stilbene, and distyrylaryl; Ar² and Ar³ are independently a hydrogen atom or an aromatic group having 6 to 20 carbon atoms; Ar¹ to Ar³ may be substituted; and x is an integer of 1 to 4. It is further preferred that at least one of Ar² and Ar³ be substituted by a styryl group.

Examples of the aromatic group having 6 to 20 carbon atoms include phenyl, naphthyl, anthranyl, phenanthryl, and terphenyl.

A preferred arylamine compound is represented by the following formula (2). 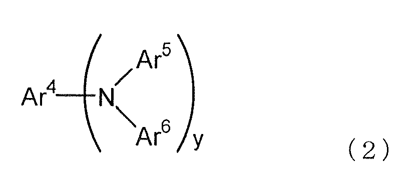 Wherein Ar⁴ to Ar⁶ are a substituted or unsubstituted aryl group having 5 to 40 nucleus atoms; and y is an integer of 1 to 4.

Examples of the aryl group having 5 to 40 nucleus atoms include phenyl, naphthyl, crycenyl, naphthacenyl, anthranyl, phenanthreyl, pyrenyl, cholonyl, biphenyl, terphenyl, pyrrolyl, furanyl, thiophenyl, benzthiophenyl, oxadiazolyl, diphenylanthranyl, indolyl, carbazoyl, pyridyl, benzoquinolyl, fluoranthenyl, acetonaphthofluoranthenyl, and stilbene. Preferred substituents for the aryl group include an alkyl group having 1 to 6 carbon atoms (ethyl, methyl, i-propyl, n-propyl, s-butyl, t-butyl, pentyl, hexyl, cyclopentyl, cyclohexyl, or the like); an alkoxy group having 1 to 6 carbon atoms (ethoxy, methoxy, i-propoxy, n-propoxy, s-buthoxy, t-buthoxy, penthoxy, hexyloxy, cyclopentoxy, cyclohexyloxy, or the like); an aryl group having 5 to 40 nucleus atoms; an amino group substituted by an aryl group having 5 to 40 nucleus atoms; an ester group with an aryl group having 5 to 40 nucleus atoms; an ester group with an alkyl group having 1 to 6 carbon atoms; a cyano group; a nitro group; and a halogen atom.

The device structure of the organic EL device can be exemplified below, including that shown in FIG. 1. The device structure is, however, not limited thereto.
(1) Anode/emitting layer/cathode
(2) Anode/hole-injecting layer/emitting layer/cathode
(3) Anode/emitting layer/electron-injecting layer/cathode
(4) Anode/hole-injecting layer/emitting layer/electron-injecting layer/cathode (FIG. 1)
(5) Anode/organic semiconductor layer/emitting layer/cathode
(6) Anode/organic semiconductor layer/electron-barrier layer/emitting layer/cathode
(7) Anode/organic semiconductor layer/emitting layer/adhesion-improving layer/cathode
(8) Anode/hole-injecting layer/hole-transporting layer/emitting layer/electron-injecting layer/cathode
(9) Anode/insulative layer/emitting layer/insulative layer/cathode
(10) Anode/inorganic semiconductor layer/insulative layer/emitting layer/insulative layer/cathode
(11) Anode/organic semiconductor layer/insulative layer/emitting layer/insulative layer/cathode
(12) Anode/insulative layer/hole-injecting layer/hole-transporting layer/emitting layer/insulative layer/cathode
(13) Anode/insulative layer/hole-injecting layer/hole-transporting layer/emitting layer/electron-injecting layer/cathode
Of these, usually, the structure (8) is preferably used.

The hole-injecting/transporting layer is a layer for helping the injection of holes into the emitting layer to transport the holes to a light emitting region. The hole mobility thereof is large and the ionization energy thereof is usually as small as 5.5 eV or less. Such a hole-injecting/transporting layer is preferably made of a material which can transport holes to the emitting layer at a lower electric field intensity. The hole mobility thereof is preferably at least 10⁻⁴ cm²/V·second when an electric field of, e.g., 10⁴ to 10⁶ V/cm is applied.

Any materials which have the above preferable properties can be used as the material for forming the hole-injecting/transporting layer without particular limitation. The material for forming the hole-injecting/transporting layer can be arbitrarily selected from materials which have been widely used as a material transporting carriers of holes in photoconductive materials and known materials used in a hole-injecting layer of an organic EL device. For example, an aromatic tertiary amine, a hydrazone derivative, a carbazole derivative, a triazole derivative, an imidazole derivative, a polyvinyl carbozole, polyethylene dioxythiophene/polysulfonic acid (PEDOT/PSS) or the like can be given. Specific examples include triazole derivatives (see USP No. 3, 112, 197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3,526,501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive high molecular oligomers (in particular thiophene oligomers) disclosed in JP-A-1-211399.

The above-mentioned substances can be used as the material for the hole-injecting layer. The following can also be used: porphyrin compounds, aromatic tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others). Aromatic tertiary amine compounds are particularly preferably used.

The following can also be given as examples: 4,4'-bis(N-(1-naphthyl)-N-phenylamino)biphenyl (abbreviated as "NPD" hereinafter), which has in the molecule thereof two condensed aromatic rings, disclosed in USP No. 5,061,569, and 4,4',4"-tris (N-(3-methylphenyl)-N-phenylamino)triphenylamin e (abbreviated as "MTDATA", hereinafter), wherein three triphenylamine units are linked to each other in a star-burst form, disclosed in JP-A-4-308688.
Inorganic compounds such as p-type Si and p-type SiC as well as aromatic dimethylidene type compounds can also be used as the material for the hole-injecting layer.

This hole-injecting/transporting layer may be a single layer made of one or two or more of the above-mentioned materials, or may be stacked hole-injecting/transporting layers made of different compounds.

The organic semiconductor layer is a layer for helping the injection of holes or electrons into the emitting layer, and is preferably a layer having an electric conductivity of 10⁻¹⁰ S/cm or more. As the material of such an organic semiconductor layer, electroconductive oligomers such as thiophene-containing oligomers or arylamine-containing oligomers disclosed in JP-A-8-193191, and electroconductive dendrimers such as arylamine-containing dendrimers may be used.

The electron-injecting layer is a layer for helping the injection of electrons into an emitting layer, and has a large electron mobility. An adhesion-improving layer is a layer made of a material particularly good in adhesion to a cathode among such electron-injecting layers. The material used in the electron-injecting layer is preferably a metal complex of 8-hydroquinoline or a derivative thereof, or an oxadiazole derivative.

As specific examples of a metal complex of 8-hydroxyquinoline or a derivative thereof, metal chelate oxinoid compounds including a chelate of oxine (usually, 8-quinolinol or 8-hydroxyquinoline) can be given. For example, tris(8-quinolinol)aluminum (Alq) may be used in the electron-injecting layer.
An electron-transporting compound represented by the following formula can be given as the oxadiazole derivative.

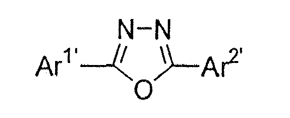

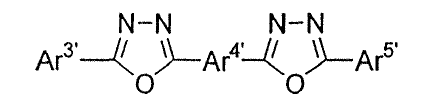

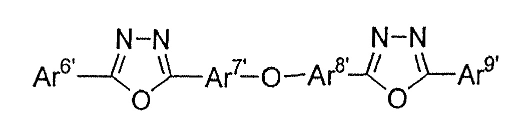

wherein Ar^{1'}, Ar^{2'}, Ar^{3'}, Ar^{5'}, Ar^{6'} and Ar⁹' are independently a substituted or unsubstituted aryl group and may be the same or differen; and Ar^{4'}, Ar^{7'} and Ar^{8'} are independently a substituted or unsubstituted arylene group and may be the same or different.
As examples of the aryl group, a phenyl group, a biphenyl group, an anthranyl group, a perylenyl group, and a pyrenyl group can be given. As examples of the arylene group, a phenylene group, a naphthylene group, a biphenylene group, an anthranylene group, a perylenylene group, a pyrenylene group, and the like can be given. As the substituent, an alkyl group having 1 to 10 carbon atoms, an alkoxy group having 1 to 10 carbon atoms, a cyano group, and the like can be given. The electron-transporting compound is preferably one from which a thin film can be formed.

The following compounds can be given as specific examples of the electron-transporting compound.

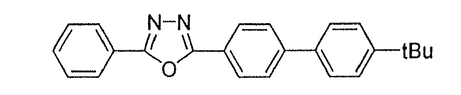

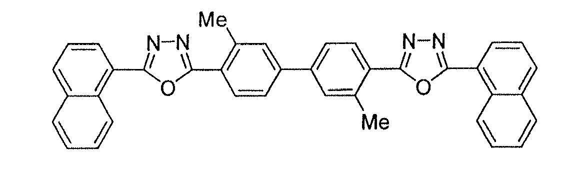

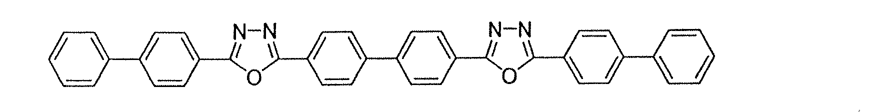

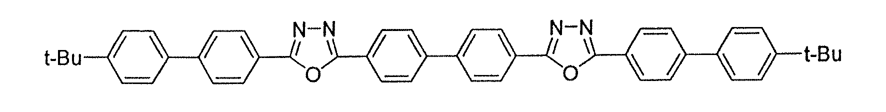

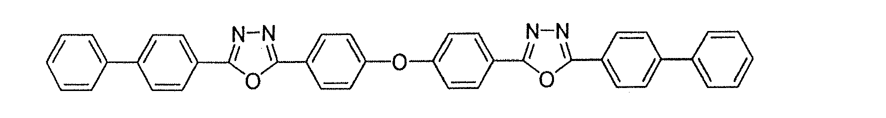

In the organic EL device, an electron-injecting layer made of an insulator or a semiconductor may further be provided between a cathode and an organic layer. By providing the layer, current leakage can be effectively prevented to improve the injection of electrons.
As the insulator, at least one metal compound selected from the group consisting of alkali metal calcogenides, alkaline earth metal calcogenides, halides of alkali metals and halides of alkaline earth metals can be preferably used. When the electron-injecting layer is formed of the alkali metal calcogenide or the like, the injection of electrons can be preferably further improved. Specifically preferable alkali metal calcogenides include Li₂O, LiO, Na₂S, Na₂Se and NaO and preferable alkaline earth metal calcogenides include CaO, BaO, SrO, BeO, BaS and CaSe. Preferable halides of alkali metals include LiF, NaF, KF, LiCl, KCl and NaCl. Preferable halides of alkaline earth metals include fluorides such as CaF₂, BaF₂, SrF₂, MgF₂ and BeF₂ and halides other than fluorides.

Examples of the semiconductor for forming an electron-injecting layer include oxides, nitrides or oxynitrides containing at least one element selected from Ba, Ca, Sr, Yb, Al, Ga, In, Li, Na, Cd, Mg, Si, Ta, Sb and Zn, and combinations of two or more thereof. An inorganic compound forming an electron-transporting layer is preferably a microcrystalline or amorphous insulative thin film. When the electron-transporting layer is formed of the insulative thin films, more uniformed thin film is formed, whereby pixel defects such as a dark spot are decreased. Examples of such an inorganic compound include the above-mentioned alkali metal calcogenides, alkaline earth metal calcogenides, halides of alkali metals, and halides of alkaline earth metals.

In the organic EL device, pixel defects due to leakage or a short circuit are easily generated since an electric field is applied to super thin films. In order to prevent this, it is preferred to insert an insulative thin layer between a pair of electrodes.
Examples of the material used in the insulative layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide. A mixture or laminate thereof may be used.

The film thickness of each of the organic layers forming the organic thin layer in the organic EL device of the invention is not particularly limited. In general, defects such as pinholes are easily generated when the film thickness is too small. Conversely, when the film thickness is too large, a high applied voltage becomes necessary, leading to low efficiency. Usually, the film thickness is preferably in the range of several nanometers to one micrometer.

The anode of the organic EL device plays a role for injecting holes into its hole-injecting/transporting layer or emitting layer. The anode effectively has a work function of 4.5 eV or more. Tin-doped indium oxide alloy (ITO), tin oxide (NESA), gold, silver, platinum, copper, and the like may be used as the material for the anode.
The anode can be formed by forming these electrode materials into a thin film by vapor deposition, sputtering or the like.
In the case where emission from the emitting layer is outcoupled through the anode, it is preferred to make the transmittance of the anode to the emission larger than 10%. The sheet resistance of the anode is preferably several hundreds Ω/□ or less. The film thickness of the anode, which varies depending upon the material thereof, is usually from 10 nm to 1 µm, preferably from 10 to 200 nm.

The cathode of the organic EL device plays a role for injecting electrons into its electron-injecting/transporting layer or emitting layer. For the cathode, the following may be used: an electrode substance made of a metal, an alloy or an electroconductive compound, or a mixture thereof which has a small work function (4 eV or less). Specific examples of the electrode substance include sodium, sodium-potassium alloys, magnesium, lithium, magnesium/silver alloys, aluminum/aluminum oxide, aluminum/lithium alloys, indium, and rare earth metals.
This cathode can be formed by making the electrode substances into a thin film by vapor deposition, sputtering or some other method. In the case where emission from the emitting layer is outcoupled through the cathode, it is preferred to make the transmittance of the cathode to the emission larger than 10%. The sheet resistance of the cathode is preferably several hundreds Ω/□ or less, and the film thickness thereof is usually from 10 nm to 1 µm, preferably from 50 to 200 nm.

The organic EL device of the invention is generally formed on a transparent substrate. The transparent substrate as referred to herein is a substrate for supporting the organic EL device, and is preferably a flat and smooth substrate having a transmittance of 50% or more to light rays within visible ranges of 400 to 700 nm.
Specific examples thereof include glass plates and polymer plates. Examples of the glass plate include soda-lime glass, barium/strontium-containing glass, lead glass, aluminosilicate glass, borosilicate glass, barium borosilicate glass, and quartz. Examples of the polymer plate include polycarbonate, acrylic polymer, polyethylene terephthalate, polyethersulfide, and polysulfone.

### EXAMPLES

In the examples, the water concentration of a solvent (solution) was measured by the Karl Fischer titration method. The oxygen concentration of a solvent (solution) was measured using a dissolved oxygen monitor (UC-12-SOL, manufactured by Central Kagaku Corp.). The value (mg/L) obtained by the measurement was converted providing that the specific gravity of toluene was 0.8669 (20°C) and expressed as ppm.

### Example 1

### (1) Preparation of organic solvent

Toluene was prepared as an organic solvent. After being subjected to nitrogen bubbling in a glove box with an oxygen concentration of 1 ppm and a dew point of -70°C, toluene was passed through a degasser (DEGASSER MULTIPLEX U005, manufactured by ERC, Inc.). The water concentration and the oxygen concentration of the toluene thus prepared were 1 ppm and 0.6 ppm, respectively.

### (2) Preparation of ink A

In an atmosphere of argon, 0.1 g of the compound H shown below (host material) and 0.01 g of the compound D shown below (dopant) were added to 10 g of the toluene prepared in (1) above, and dissolved. The water concentration and the oxygen concentration of the ink A thus prepared were 1 ppm and 0. 6 ppm, respectively. The compounds H and D were produced by the method described in Japanese Patent Application No. 2003-417037 (JP-A-2005-170911).

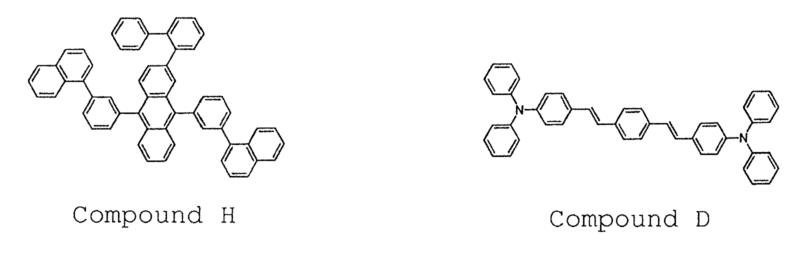

### (3) Fabrication of organic EL device

A grass substrate of 25 mm by 75 mm by 1.1 mm thick with an ITO transparent electrode (GEOMATEC CO., LTD.) was subjected to ultrasonic cleaning with isopropyl alcohol for 5 minutes, and cleaned with ultraviolet rays and ozone for 30 minutes. On the substrate, a 100 nm-thick film of polyethylene dioxythiophene/polystyrenesulfonic acid (PEDOT·PSS), as a hole-injecting layer, was formed by spin coating. Then an emitting layer was formed by spin coating on the DEPOT·PSS film by using the ink A prepared. The film thickness of the emitting layer was 50 nm. A 10 nm-thick tris (8-quinolinol) aluminum film (Alq film) was formed thereon. This Alq film functions as an electron-transporting layer. Then, Li as a reductive dopant (Li source: manufactured by SAES Getters Co., Ltd.) and Alq were co-deposited, whereby an Alq:Li film was formed as an electron-injecting layer (cathode). Metal aluminum was deposited thereon to form a metal cathode, thereby fabricating an organic EL device. The device emitted blue light and the emitting surface was uniform. The half life of luminance when the device was driven at 100 cd/m² was 300 hours.

### Comparative Example 1

### (1) Preparation of ink B

In an atmosphere of argon, 0.1 g of the above compound H (host material) and 0.01 g of the above compound D (dopant) were added to 10 g of the toluene having a water concentration of 34 ppm and oxygen concentration of 11 ppm, respectively, and dissolved. The water concentration and the oxygen concentration of the ink B thus prepared were 55 ppm and 45 ppm, respectively.

### (2) Fabrication of organic EL device

A device was fabricated in the same manner as in the fabrication of a device in Example 1(3), except that the ink B was used instead of the ink A. Many dark spots were observed on the emitting surface. The half life of luminance when the device was driven at 100 cd/m² was 10 hours or less.

### Example 2

### (1) Preparation of organic solvent

Toluene was prepared in the same manner as in Example 1(1).

### (2) Preparation of ink C

In an atmosphere of argon, 0.1 g of the above compound H (host material) and 0.005 g of the compound (dopant) shown below were added to 10 g of the toluene prepared in (1) above, and dissolved. The water concentration and the oxygen concentration of the ink C thus prepared were 1 ppm and 0. 6 ppm, respectively.

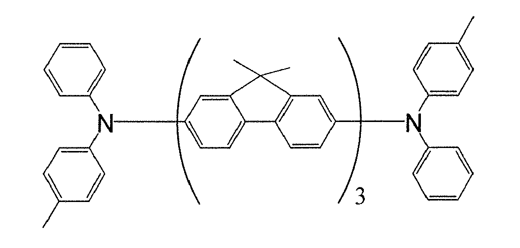

### (3) Fabrication of device

An organic EL device was fabricated in the same manner as in Example 1(3), except that the ink C was used instead of the ink A. The device emitted blue light, and the emitting surface was uniform. The half life of luminance when the device was driven at 100 cd/m² was 320 hours.

### INDUSTRIAL APPLICABILITY

An organic EL apparatus prepared using the ink for forming an organic EL coating film of the invention can be used as a display for commercial and industrial uses, specifically as an organic EL panel for portable phones, PDAs, car navigators, monitors, and TVs.

## Claims

1. An ink for forming an organic electroluminescent coating film having a water concentration of 20 ppm or less and an oxygen concentration of 10 ppm or less wherein an aromatic compound is dissolved in an organic solvent.

2. The ink for forming an organic electroluminescent coating film according to claim 1 wherein the aromatic compound is an anthracene derivative, a pyrene derivative, and/or a fluorene derivative.

3. The ink for forming an organic electroluminescent coating film according to claim 2 wherein the fluorene derivative is an oligofluorenylene compound represented by the following formula: 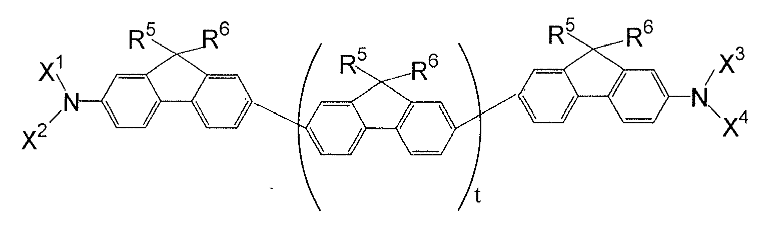 wherein X¹ to X⁴ are a group selected from the group consisting of substituted or unsubstituted alkyl, aralkyl, aryl and heterocycle, substituted or unsubstituted alkenyl having a substituted or unsubstituted arylene or linking group formed of a divalent heterocyclic group, alkynyl, amino, alkoxy and sulfide, substituted silyl having a substituted or unsubstituted arylene group or linking group formed of a divalent heterocyclic group, and carbonyl; X¹ to X⁴ may be the same or different; X¹ and X², and X³ and X⁴ may be bonded together to form a ring;
R⁵ and R⁶ are a group selected from the group consisting of hydrogen, substituted or unsubstituted alkyl, aralkyl and aryl; R⁵ and R⁶ may be the same or different; R⁵s or R⁶s bonding different fluorenylene rings may be the same or different; and
t is an integer of 1 to 20.

4. The ink for forming an organic electroluminescent coating film according to any one of claims 1 to 3 wherein the organic solvent is a non-halogen solvent.

5. The ink for forming an organic electroluminescent coating film according to claim 4 wherein the organic solvent is an aromatic solvent.

6. The ink for forming an organic electroluminescent coating film according to any one of claims 1 to 3 wherein the organic solvent is a non-halogen solvent.

7. A method for producing the ink for forming an organic electroluminescent coating film of any one of claims 1 to 6 comprising dissolving an aromatic compound into an organic solvent having a water concentration of 20 ppm or less and an oxygen concentration of 10 ppm or less.

8. An organic electroluminescent device produced by using the ink for forming an organic electroluminescent coating film of any one of claims 1 to 6.
